# EUROPÄISCHE PATENTSCHRIFT

(11) **EP 2 856 192 B1**
(45) Veröffentlichungstag und Bekanntmachung des Hinweises auf die Patenterteilung: **02.08.2017**
(21) Anmeldenummer: 13728985.6
(22) Anmeldetag: 29.05.2013
(51) Int. Cl.: G01N 27/04, G01R 27/02, G01R 27/16, G01R 31/02, G01R 31/42

(54) **ISOLATIONSWIDERSTANDSMESSUNG FÜR WECHSELRICHTER**
INSULATION RESISTANCE MEASUREMENT FOR INVERTERS
MESURE DE RÉSISTANCE D'ISOLATION POUR ONDULEURS

(30) Priorität: 01.06.2012 DE 102012104752
(43) Veröffentlichungstag der Anmeldung: 08.04.2015
(73) Patentinhaber: SMA Solar Technology AG, 34266 Niestetal (DE)
(72) Erfinder: MÜLLER, Burkard, 34123 Kassel (DE)
(74) Vertreter: Lahnor, Peter
(86) Internationale Anmeldenummer: PCT/EP2013/061019
(87) Internationale Veröffentlichungsnummer: WO 2013/178654

(56) Entgegenhaltungen:
- EP-A2- 1 143 594
- CN-A- 102 298 091
- JP-A- H0 694 762
- JP-A- 2006 238 573
- US-A1- 2012 026 631

## Beschreibung

Die Erfindung bezieht sich auf ein Verfahren zur Messung des Isolationswiderstands für einen Wechselrichter mit den Merkmalen des Oberbegriffs des unabhängigen Patentanspruchs 1 sowie auf einen Wechselrichter mit mindestens einer zwei aktive Schaltelemente aufweisenden Halbbrücke und mit einer Vorrichtung zum Messen eines Isolationswiderstands nach dem Oberbegriff des unabhängigen Patentanspruchs 7.

Der Wechselrichter kann insbesondere ein PV-Wechselrichter sein, d. h. elektrische Energie von einem Photovoltaikgenerator in ein Wechselstromnetz einspeisen.

Der Wechselrichter kann einen ausgangsseitigen Transformator aufweisen. Es kann sich aber insbesondere auch um einen transformatorlosen Wechselrichter handeln.

Der gemessene Isolationswiderstand schließt zwar denjenigen des Wechselrichters selbst ein, insbesondere handelt es sich aber um den Isolationswiderstand einer an den Wechselrichter eingangsseitig angeschlossenen Stromquelle, d. h. beispielsweise eines PV-Generators.

Im Betrieb des Wechselrichters kann die Stromquelle einen Erdbezug aufweisen. So kann beispielsweise einer ihrer Pole im Betrieb des Wechselrichters geerdet sein. Auch im Betrieb eines transformatorlosen Wechselrichters an einem geerdeten Netz wird über die an den Ausgängen des Wechselrichters anliegende Netzspannung ein Erdbezug einer ansonsten ungeerdeten Stromquelle hergestellt. Für die Messung des Isolationswiderstands sind derartige Erdverbindungen jedoch aufzuheben, da der Isolationswiderstand gegen Erde gemessen wird.

### STAND DER TECHNIK

Aus der EP 1 857 825 A1 und der dazu parallelen US 7,576,547 B2 ist eine Messanordnung mit einem Erdungspunkt zur Ermittlung des Isolationswiderstands einer unter Spannung stehenden elektrischen Vorrichtung oder einer Anlage mit einer Versorgungsspannung mit einem Pluspol und einem Minuspol bekannt. Dabei sind zwei Schalter oder ein entsprechender Umschalter vorgesehen, die jeweils einen Strompfad zwischen einem der beiden Pole und einem Erdungspunkt herstellen, um bei Auftreten einer oder mehrerer Isolationsfehler mit beliebigem Potentialbezug den sich insgesamt ergebenden Isolationswiderstand zu ermitteln. Zur Ermittlung des Isolationswiderstands werden zwei aufeinanderfolgende Messungen durchgeführt, wobei bei der ersten dieser Messungen der erste Schalter geschlossen ist, während der zweite Schalter geöffnet ist, und wobei bei der zweiten dieser Messungen der erste Schalter geöffnet ist, während der zweite Schalter geschlossen ist. Bei den Messungen wird der über die jeweils hergestellte Verbindung zu dem Erdungspunkt fließende Strom gemessen. Aus den beiden gemessenen Strömen wird der Isolationswiderstand berechnet, wozu die genannten Druckschriften eine detaillierte Anleitung geben.

Die bekannte Messanordnung kann konkret dazu vorgesehen sein, eine Photovoltaikanlage auf einen Isolationsfehler zu überwachen, die elektrische Energie von einem Photovoltaikgenerator in ein Wechselstromnetz einspeist. Die zur Ausbildung der bekannten Messanordnung an einem Wechselrichter vorzusehenden Bauteile sind zahlreich und erhöhen die Gesamtkosten des Wechselrichters erheblich.

Aus der DE 10 2006 031 663 B3 ist ein Verfahren zur Messung des Isolationswiderstands in einem IT-Netz bekannt. Dieses IT-Netz weist einen Gleichspannungszwischenkreis und einen selbstgeführten Stromrichter mit einem ersten und einem zweiten Leistungsschalter auf. Weiterhin ist eine Messanordnung zur Messung der Zwischenkreisspannung gegen Erde bestehend aus einem Spannungsteiler und zwei zugeordneten Potentialmesseinrichtungen Teil des IT-Netzes. Das Verfahren umfasst eine Offline-Messung beispielsweise zu Betriebsbeginn, bei der alle ersten oder alle zweiten Leistungsschalter des Stromrichters geschlossen sind. In diesem Schaltzustand werden die beiden Potentiale des Zwischenkreises sowie die Zwischenkreisspannung gemessen und daraus der Isolationswiderstand bestimmt.

Aus der DE 10 2010 054 413 A1 ist ein Verfahren zum Lokalisieren eines Isolationsfehlers in einem System bekannt, das einen DC-Abschnitt mit einer High Side und einer Low Side und einen AC-Abschnitt einschließlich eines Wechselrichters mit einer Reihenschaltung aus zwei Leistungsschaltern, die zwischen die High Side und die Low Side geschaltet sind, aufweist. Der DC-Abschnitt wird mit einer Gleichspannung einer Gleichspannungsquelle versorgt. Es erfolgen ein Durchschalten des unmittelbar an der High Side anliegenden Leistungsschalters, ein Durchschalten des unmittelbar an der Low Side anliegenden Leistungsschalters, ein Messen jeweils einer High Side-Isolationsspannung zwischen der High Side und einer Masse sowie einer Low Side-Isolationsspannung zwischen der Low Side und der Masse in jedem der beiden Durchschaltzustände und schließlich auf Basis der Messergebnisse ein Ermitteln, ob ein Isolationsfehler in dem DC- oder AC-Abschnitt vorliegt.

Ein Verfahren mit den Merkmalen des Oberbegriffs des Patentanspruchs 1 und eine Vorrichtung mit den Merkmalen des Oberbegriffs des unabhängigen Patentanspruchs 7 sind aus der US 2012/0026631 A1 bekannt. Hier wird der über die Verbindung zu dem Erdungspunkt fließende Strom mit einem Stromsensor gemessen. Zusätzlich werden die Potentiale der ungeerdeten Pole der Zwischenkreisspannung gemessen.

Gemäß der EP 1 143 594 A2 wird ein Erdungsfehler bei einer Solaranlage mit Hilfe eines Differenzstromsensors erfasst. Dabei wird mit einem Wechselrichter, der Strom von der Solaranlage in ein Wechselstromnetz einspeist, das Potential von Anschlüssen der Solaranlage an den Wechselrichter gegenüber einem Erdungspunkt des Wechselstromnetzes verschoben.

Aus der erst nach dem Prioritätstag der vorliegenden Anmeldung veröffentlichten DE 10 2011 007 222 A1 geht eine Wechselrichterschaltung hervor, bei der zur Isolationsüberwachung ein Spannungsteilerverhältnis eines zur Isolationsüberwachung verwendeten Spannungsteilers mittels AC-Spannungsmesswiderständen des Wechselrichters verändert wird, indem diese mittels IGBTs einer Brückenschaltung mit Zwischenkreispotentialen gekoppelt werden. Im normalen Betrieb des Wechselrichters stellt die an den AC-Spannungsmesswiderständen anstehende Spannung den momentanen Wert der Ausgangsspannung dar und wird zu deren Regelung verwendet. Die Isolationsüberwachung erfolgt durch Spannungsmessung einer Ist-Spannung in Form einer Potentialdifferenz zwischen einem Zwischenkreispotential und Erde. Die Ist-Spannung wird mit einer von der Schaltstellung der IGBTs abhängigen, vorgegebenen Soll-Spannung verglichen. Ein Isolationsfehler wird angezeigt, wenn eine Differenz zwischen der Ist- und der Soll-Spannung ein vorgegebenes Maß überschreitet.

### AUFGABE DER ERFINDUNG

Der Erfindung liegt die Aufgabe zugrunde, ein Verfahren zur Messung eines Isolationswiderstands für einen Wechselrichter und einen Wechselrichter mit einer Vorrichtung zum Messen eines Isolationswiderstands bereitzustellen, die eine aktive Messung des Isolationswiderstands anwenden, ohne dass hierfür hohe Kosten anfallen.

### LÖSUNG

Erfindungsgemäß wird die Aufgabe der Erfindung durch ein Verfahren mit den Merkmalen des unabhängigen Patentanspruchs 1 und einen Wechselrichter mit den Merkmalen des unabhängigen Patentanspruchs 7 gelöst. Bevorzugte Ausführungsformen des erfindungsgemäßen Verfahrens sind in den abhängigen Patentansprüchen 2 bis 6 beschrieben. Die abhängigen Patentansprüche 8 bis 15 betreffen bevorzugte Ausführungsformen des erfindungsgemäßen Wechselrichters.

### BESCHREIBUNG DER ERFINDUNG

Bei einer erfindungsgemäßen Umsetzung des Prinzips der aktiven Messung des Isolationswiderstands für einen Wechselrichter wird ein zwischen den beiden aktiven Schaltelementen einer Halbbrücke des Wechselrichters liegender Mittelpunkt durch Schließen eines Erdschalters mit einem Erdungspunkt verbunden. Der mit dem Erdungspunkt verbundene Mittelpunkt wird dann mittels der Schaltelemente der Halbbrücke, die im normalen Betrieb des Wechselrichters zum Treiben eines Ausgangsstroms verwendet werden, nacheinander mit den beiden ungeerdeten Polen einer an der Halbbrücke anliegenden Zwischenkreisspannung des Wechselrichters verbunden. Der über die derart mit dem Erdungspunkt hergestellte Verbindung fließende Strom wird gemessen. Die Auswertung der Messwerte erfolgt dann in grundsätzlich bekannter Weise.

Wenn keine eingangsseitigen DC/DC-Steller verwendet werden, ist die Zwischenkreisspannung, die an der Halbbrücke des Wechselrichters anliegt und deren Pole wechselweise mit dem Erdungspunkt verbunden werden, gleich einer Eingangsspannung des Wechselrichters, die von der angeschlossenen Stromquelle bereitgestellt wird.

Wenn bei der Definition der vorliegenden Erfindung auf einen zu dem Erdungspunkt fließenden Strom verwiesen wird, so wird damit nicht auf eine bestimmte Stromflussrichtung Bezug genommen. Die Stromflussrichtung hängt vielmehr von der Polarität der Spannung gegenüber Erde ab, die diesen Strom treibt. Da die beiden Pole der Zwischenkreisspannung des Wechselrichters normalerweise unterschiedliche Polaritäten gegenüber Erde aufweisen, ändert sich die Stromflussrichtung zumindest dann, wenn der Mittelpunkt der Halbbrücke zunächst länger mit dem einen und dann länger mit dem anderen Pol der Zwischenkreisspannung verbunden wird.

Das erfindungsgemäße Verfahren macht für die Herstellung der Verbindung der beiden ungeerdeten Pole der Zwischenkreisspannung des Wechselrichters mit dem Erdungspunkt von den aktiven Schaltelementen einer Halbbrücke des Wechselrichters Gebrauch. Das heißt, als Schalter zum Zuschalten der beiden Pole der Zwischenkreisspannung werden in dem Wechselrichter sowieso vorhandene und mit entsprechenden Spannungen belastbare Schaltelemente verwendet. Allein hierdurch können die Kosten der Messung des Isolationswiderstands an einem Wechselrichter gegenüber einer aus der EP 1 857 825 A1 und der parallelen US 7,576,547 B2 bekannten separaten Messanordnung deutlich reduziert werden. Die für das Messen des Isolationswiderstands herzustellende Verbindung zwischen dem Mittelpunkt der Halbbrücke und dem Erdungspunkt erfordert demgegenüber keinen stärker belastbaren Schalter, insbesondere wenn in dieser Verbindung ein höherohmiger Schutzwiderstand vorgesehen wird.

Bei dem erfindungsgemäßen Verfahren zur Messung des Isolationswiderstands werden nicht nur die Schaltelemente der Halbbrücke des Wechselrichters in einer im Vergleich mit dem normalen Betrieb des Wechselrichters beim Einspeisen in ein angeschlossenes Wechselstromnetz ungewöhnlichen Weise angesteuert, sondern der Wechselrichter ist zum Zeitpunkt der Messung noch nicht mit dem Wechselstromnetz verbunden, oder er wird für die Messung des Isolationswiderstands wieder von dem in seinem normalen Betrieb angeschlossenen Wechselstromnetz getrennt.

Konkret können die Schaltelemente bei dem erfindungsgemäßen Messverfahren nacheinander und jeweils nur einmal während der Messung geschlossen werden, um nacheinander zwei Gleichströme von den beiden Polen der Zwischenkreisspannung über die Verbindung zu dem Erdungspunkt fließen zu lassen. Dies entspricht einer Umsetzung des aus der EP 1 857 825 A1 und der US 7,576,547 B2 bekannten Messprinzips. Diese Umsetzung setzt jedoch voraus, dass die Schaltelemente der Halbbrücke für eine erheblich, d. h. um ein Vielfaches längere Zeit geschlossen werden können, als dies im normalen Wechselrichterbetrieb erforderlich ist. Auch wenn die dabei auftretenden Belastungen der Schaltelemente, insbesondere wenn in der Verbindung mit dem Erdungspunkt ein Schutzwiderstand angeordnet wird, nur gering sind, kann ein anhaltendes Schließen trotzdem unmöglich sein, weil zum Beispiel die Treiber der Schaltelemente mithilfe einer Bootstrap-Schaltung mit Spannung versorgt werden.

Auch in diesem Fall ist jedoch eine Ausführungsform des erfindungsgemäßen Verfahrens anwendbar, bei der die Schaltelemente angesteuert werden, um einen periodischen Wechselstrom über die Verbindung durch eine Netzdrossel des Wechselrichters zu dem Erdungspunkt fließen zu lassen oder um mindestens eine treibende Spannung für den Strom zu dem Erdungspunkt an dem Mittelpunkt der Halbbrücke einzustellen, die zwischen den Spannungen der beiden Pole der Zwischenkreisspannung gegenüber Erde liegt. Das heißt, die Schaltelemente können beispielsweise nach dem Prinzip einer Pulsweitenmodulation so angesteuert werden, dass über ein Filter aus Netzdrossel und evtl. weiteren Elementen wie Filterkondensator und Schutzwiderstand ein Wechselstrom in den Erdungspunkt getrieben wird. Dieser Wechselstrom kann nicht nur sinusförmig, sondern beispielsweise auch rechteckförmig sein und weist, damit er eine sinnvolle Messung des Isolationswiderstands auch bei größeren Ableitkapazitäten einer an den Wechselrichter angeschlossenen Stromquelle erlaubt, eine sehr niedrige Frequenz auf. Konkret kann die Periodendauer des zum Messen des Isolationswiderstands geformten Wechselstroms um mindestens einen Faktor 2, vorzugsweise um mindestens einen Faktor 5, noch mehr bevorzugt um mindestens einen Faktor 10, noch mehr bevorzugt um mindestens einen Faktor 50 und am meisten bevorzugt um mindestens einen Faktor 100 längere Periodendauer aufweisen als ein im Normalbetrieb des Wechselrichters durch die Netzdrossel ausgegebener Wechselstrom. Anders gesagt kann die Periodendauer des Wechselstroms zur Messung des Isolationswiderstands durchaus ein oder mehrere und sogar einige zehn Sekunden betragen. Die ideale Periodenlänge für eine ausreichend exakte Messung des Isolationswiderstands hängt dabei von der Zeitkonstante aus den vorhandenen Ableitkapazitäten und dem Isolationswiderstand selbst ab, wobei letzterer beispielsweise bei einem an den Wechselrichter angeschlossenen Photovoltaikgenerator durch klimatische Bedingungen stark variieren kann. Aus dem niederfrequenten Wechselstrom lässt sich der gesuchte Isolationswiderstand berechnen, wenn zugleich die ihn treibende Wechselspannung erfasst wird. Dies kann mit einer Messeinrichtung geschehen, die die Wechselspannung misst, wenn sie zum Beispiel über einem Filterkondensator abfällt.

Wenn die den Strom zum Erdungspunkt treibende Spannung relativ zu einem der Pole der Zwischenkreisspannung erfasst wird oder sie wegen einer definierten Ansteuerung der Schaltelemente der Halbbrücke als bekannt unterstellt werden kann, kann zur Messung des über die Verbindung zu dem Erdungspunkt fließenden Stroms auch eine Spannung gemessen werden, die zwischen einem Punkt, welcher zwischen dem schon erwähnten Schutzwiderstand für den Erdschalter und dem Erdungspunkt liegt, und dem einen der Pole der Zwischenkreisspannung abfällt. Dies gilt unabhängig davon, ob es sich bei der treibenden Spannung um eine Wechselspannung oder eine zumindest vorübergehend konstante Spannung, wie beispielsweise eine zwischen den Spannungen der beiden Pole der Zwischenkreisspannung gegenüber Erde liegende Spannung handelt. Aufgrund der Maschenregel ist die Summe der Spannung zwischen diesem Punkt und dem einen der Pole der Zwischenkreisspannung einerseits und der treibenden Spannung relativ zu diesem einen der Pole andererseits gleich der über dem Schutzwiderstand abfallenden Spannung. Aus der über dem Schutzwiderstand abfallenden Spannung lässt sich der zu dem Erdungspunkt fließende Strom berechnen. Bei dem erfindungsgemäßen Verfahren können die Spannungen, die zum Erfassen der zu dem Erdungspunkt fließenden Strömen erfasst werden, aber auch direkt, d. h. ohne explizite Umrechnung in Stromstärken, als Maß für die Ströme zur Berechnung des interessierenden Isolationswiderstands verwendet werden.

Wenn der Punkt, an dem die Spannung gegenüber dem einen der Pole der Zwischenkreisspannung gemessen wird, um den über die Verbindung zu dem Erdungspunkt fließenden Strom zu messen, zwischen dem Schutzwiderstand und dem Erdschalter liegt, kann die Spannungsmessung an diesem Punkt auch im normalen Betrieb des Wechselrichters, d. h. bei geöffnetem Erdschalter, durchgeführt und verwendet werden, um zum Beispiel die Spannung am Ausgang des Filters zu erfassen.

Wenn in dieser Beschreibung von einem Wechselstrom zu dem Erdungspunkt und einer ihn treibenden Wechselspannung die Rede ist, so bedeutet dies nicht, dass der zu dem Erdungspunkt fließende Strom seine Stromflussrichtung und die ihn treibende Spannung gegenüber Erde entsprechend ihre Polarität ändern muss. Die Ansteuerung der Schaltelemente der Halbbrücke kann zum Beispiel auch so erfolgen, dass der Momentanwert der treibenden Wechselspannung um weniger als die Hälfte der Zwischenkreisspannung variiert und die Wechselspannung einen Gleichspannungsoffset in Richtung eines Pols der Zwischenkreisspannung aufweist, so dass der von ihr getriebene Strom eine feste Stromflussrichtung aufweist.

Zum wechselweisen Verbinden der beiden Pole der Zwischenkreisspannung des Wechselrichters mit einem Erdungspunkt weist die zur Messung eines Isolationswiderstands vorgesehene Vorrichtung eines erfindungsgemäßen Wechselrichters keine zusätzlichen Schalter auf, sondern macht hierzu von den Schaltelementen einer Halbbrücke des Wechselrichters Gebrauch. Zusätzlich zur eigentlichen Wechselrichterschaltung des Wechselrichters weist die Vorrichtung jedoch einen Erdschalter auf, um den Mittelpunkt der Halbbrücke mit dem Erdungspunkt zu verbinden. Dieser Schalter ist zwischen dem Mittelpunkt der Halbbrücke und dem Erdungspunkt mit einem Messwiderstand in Reihe geschaltet, um den nach Erde fließenden Strom zu messen. Dieser Messwiderstand ist typischerweise mit einem zusätzlichen Schutzwiderstand in Reihe geschaltet, der den zu dem Erdungspunkt fließenden Strom begrenzt. Der Messwiderstand kann alternativ auch selbst als Schutzwiderstand ausgelegt sein. Zur Trennung des Mittelpunkts der Halbbrücke von einem ausgangsseitig an den Wechselrichter angeschlossenen Wechselstromnetz greift die Vorrichtung auf einen Netzschalter, ein Netzrelais oder -schütz des Wechselrichters zurück.

Zum Messen der treibenden Wechselspannung des Wechselstroms kann die Vorrichtung zur Messung des Isolationswiderstands eine zusätzliche Messeinrichtung aufweisen, die die über einem Filterkondensator abfallende Wechselspannung misst.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere der relativen Anordnung mehrerer Bauteile zueinander sowie deren Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Wenn hingegen nur die genaue Anzahl eines Merkmals angegeben werden soll, findet das Adjektiv "genau" vor dem jeweiligen Merkmal Verwendung. Diese Merkmale können durch andere Merkmale ergänzt werden oder die einzigen Merkmale sein, aus denen das jeweilige Erzeugnis besteht.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1**: illustriert einen nicht unter den Wortlaut der Patentansprüche fallenden Wechselrichter mit einer Vorrichtung zur Messung eines Isolationswiderstands.
- **Fig. 2**: illustriert einen zweiten nicht unter den Wortlaut der Patentansprüche fallenden Wechselrichter mit einer Vorrichtung zur Messung eines Isolationswiderstands.
- **Fig. 3**: illustriert die wesentlichen Bestandteile einer ersten Ausführungsform eines erfindungsgemäßen Wechselrichters mit einer Vorrichtung zur Messung eines Isolationswiderstands; und
- **Fig. 4**: illustriert die wesentlichen Bestandteile einer weiteren Ausführungsform eines erfindungsgemäßen Wechselrichters mit einer Vorrichtung zur Messung eines Isolationswiderstands.

### FIGURENBESCHREIBUNG

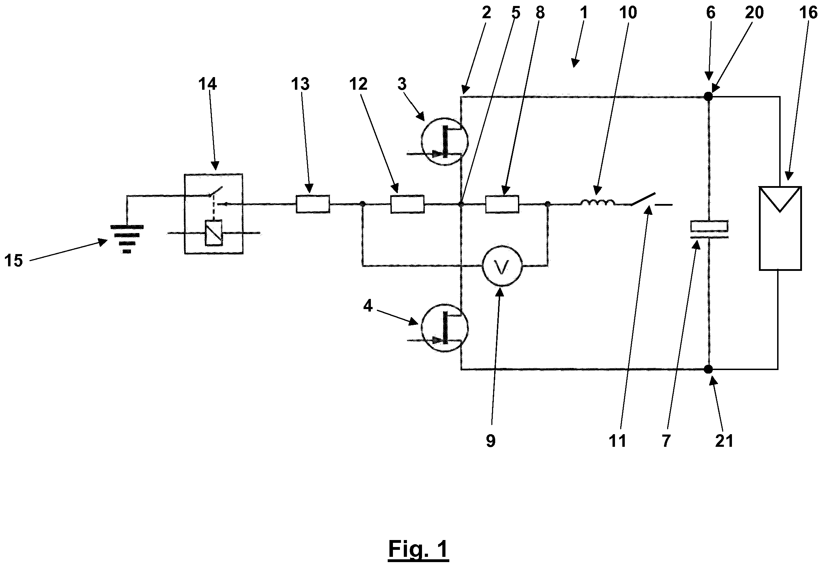

In **Fig. 1** ist ein Wechselrichter 1 in Form seiner hier wesentlichen Teile dargestellt, zu denen eine Halbbrücke 2 mit Schaltelementen 3 und 4 auf beiden Seiten eines Mittelpunkts 5, ein Gleichspannungszwischenkreis 6 mit einem Zwischenkreiskondensator 7, ein Messwiderstand 8 mit einer zugeordneten Messeinrichtung 9 für die darüber abfallende Spannung, eine Netzdrossel 10 und ein Netzschalter 11 zählen. Der Gleichspannungszwischenkreis 6 ist hier beispielhaft direkt an eine Stromquelle 16 angeschlossen, möglich wäre auch ein Anschluss der Stromquelle 16 an den Zwischenkreis 6 über einen nicht galvanisch trennenden DC/DC-Wandler wie z.B. einen Hochsetzsteller. Neben dem Strompfad von dem Mittelpunkt 5, der durch den Messwiderstand 8 und durch die Netzdrossel 10 zu dem Netzschalter 11 führt, über den der Wechselrichter an ein Wechselstromnetz angeschlossen werden kann, um in dieses Wechselstromnetz einzuspeisen, zweigt von dem Mittelpunkt 5 ein weiterer Strompfad ab. Dieser Strompfad führt durch einen im Vergleich zu dem Messwiderstand 8 höherohmigeren Messwiderstand 12, einen Schutzwiderstand 13 und einen Erdschalter 14 zu dem Erdungspunkt 15. Der Messwiderstand 12 ist mit dem Messwiderstand 8 zwischen den Anschlüssen der Messeinrichtung 9 in Reihe geschaltet. Sowohl Netz- als auch Erdschalter können als Relais bzw. Schütz ausgeführt sein, um sie automatisiert betätigen zu können.

Wenn bei geöffnetem Netzschalter 11 der Erdschalter 14 geschlossen wird, ist der Mittelpunkt 5 über die Widerstände 12 und 13 mit dem Erdungspunkt 15 verbunden. Dann kann durch Schließen des Schaltelements 3 der positive Pol 20 einer Zwischenkreisspannung des Gleichspannungszwischenkreises 6 mit dem Mittelpunkt 5 und damit mit dem Erdungspunkt 15 verbunden werden, um einen in der Folge zu dem Erdungspunkt 15 fließenden Strom mit der Messeinrichtung 9 zu messen. Dabei misst die Messeinrichtung 9 ausschließlich eine über den Messwiderstand 12 abfallende Spannung als Maß für den interessierenden Strom, weil aufgrund des geöffneten Netzschalters 11 durch den Messwiderstand 8 kein Strom fließt und somit über dem Messwiderstand 8 keine Spannung abfällt.

Wenn der Strom zu dem Erdungspunkt 15 gemessen ist, kann das Schaltelement 3 wieder geöffnet und anschließend das Schaltelement 4 geschlossen werden, um einen vom negativen Pol 21 der Zwischenkreisspannung des Gleichspannungszwischenkreises 7 zu dem Erdungspunkt 15 fließenden Strom in gleicher Weise zu messen. Aus den Messwerten der beiden Ströme zu dem Erdungspunkt 15 ist in bekannter Weise der Isolationswiderstand der gezeigten Anordnung bestimmbar. Hierfür werden gegenüber dem Grundaufbau des Wechselrichters 1 nur der Messwiderstand 12, der Schutzwiderstand 13 und der Erdschalter 14 als zusätzliche Bauteile benötigt. Der gemessene Isolationswiderstand wird insbesondere von Isolationswiderständen im Bereich einer an den Gleichspannungszwischenkreis 6 angeschlossenen Stromquelle 16, hier eines Photovoltaikgenerators, bestimmt, umfasst aber auch den eigenen Isolationswiderstand des Wechselrichters 1.

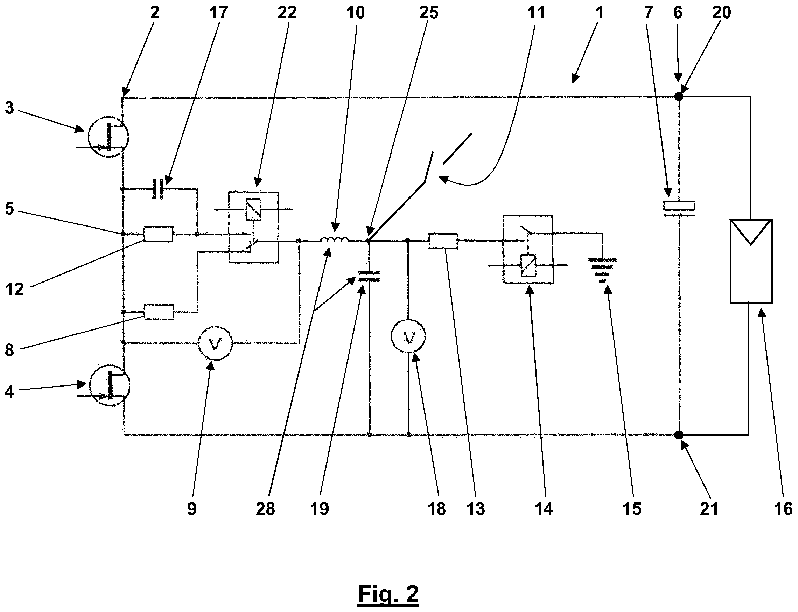

Der in **Fig. 2** anhand seiner wesentlichen Bestandteile dargestellte Wechselrichter 1 weist einen zusätzlichen Wechselschalter 22 auf, der den Strom zu der Netzdrossel 10 entweder durch den niederohmigeren Messwiderstand 8 oder durch den höherohmigeren Messwiderstand 12 führt. Dabei zweigt der Strompfad durch den Schutzwiderstand 13 und den Erdschalter 14 zu dem Erdungspunkt 15 erst hinter der Netzdrossel 10 von dem Strompfad durch den Netzschalter 11 in das hier wieder nicht dargestellte Stromnetz, in das der Wechselrichter 1 einspeist, ab. Bei dieser Topologie des Wechselrichters 1 können die Schaltelemente 3 und 4 so angesteuert werden, dass sie an einem Filterausgang 25 eines die Netzdrossel 10 und einen Filterkondensator 19 umfassenden Filters 28 einen sehr niederfrequenten Wechselspannungsanteil stellen, durch den wiederum ein sehr niederfrequenter Strom in den Erdungspunkt 15 getrieben wird. Es versteht sich, dass dabei der Netzschalter 11 geöffnet und der Erdschalter 14 geschlossen ist. Weiterhin ist ein Filterkondensator 17 dem Messwiderstand 12 parallel geschaltet, um den hochfrequenten Anteil des Stroms durch die Drossel 10 wegzufiltern.

Die treibende Spannung dieses Wechselstroms wird durch eine zusätzliche Messeinrichtung 18 über dem Filterkondensator 19 gemessen. Aus dem Verhältnis des Wechselstroms und seiner treibenden Wechselspannung ist der Isolationswiderstand des Wechselrichters 1 bestimmbar. Dazu müssen sowohl von der Spannung an dem Filterkondensator 19 als auch von dem Strom durch den Messwiderstand 12 nur die niederfrequenten Wechselanteile U_{AC} und I_{AC} ausgewertet werden. Der Isolationswiderstand Rᵢₛₒ ergibt sich dann gemäß Rᵢₛₒ = U_{AC}/I_{AC} -R₁₃, wobei R₁₃ der Wert des Schutzwiderstands 13 ist. Der Filterkondensator 19 hat dabei keine Bedeutung für die Messung von U_{AC}, nimmt aber sinnvoller Weise den hochfrequenten Rippelstrom der Netzdrossel 10 auf. Dieser entspricht dem Rippel im normalen Einspeisebetrieb des Wechselrichters 1 und ist damit um ein Vielfaches größer als der Messstrom. Würde der Filterkondensator 19 weggelassen, könnte sich der Strom in der Netzdrossel 10 nur minimal ändern, und der Schutzwiderstand 13 würde der vollen hochfrequenten Wechselspannung an dem Mittelpunkt 5 ausgesetzt, so dass seine Belastung sehr hoch wäre. Da der Filterkondensator 19 in einem Netzfilter eines Wechselrichters 1 aber ohnehin vorhanden ist, kann er die hier nötige Filterfunktion übernehmen. Die Bestimmung des Isolationswiderstands aus dem Verhältnis des Wechselstroms und seiner treibenden Wechselspannung setzt nicht voraus, dass die Schaltelemente 3 und 4 dauerhaft geschlossen werden können. Für diese Bestimmung ist auch der Wechselschalter 22 nicht zwingend erforderlich. Vielmehr könnten die Strompfade zu dem Netzschalter 11 und dem Erdschalter 14 erst nach der Netzdrossel 10 zu den Messwiderständen 8 und 12 verzweigen, wobei der Filterkondensator 17 auch dann dem Messwiderstand 12 parallel geschaltet sein könnte, obwohl in diesem Fall bereits der Filterkondensator 19 filtern würde. Häufig werden jedoch die Netzdrossel 10 und der Filterkondensator 19 direkt mit einander verbunden sein, insbesondere wenn sie als Filtereinheit miteinander und evtl. mit weiteren Bauelementen vergossen sind, so dass eine Anordnung gemäß den Zeichnungen erzwungen wird. Der übliche Ort des Messwiderstands 8 für den von der Halbbrücke 2 getriebenen Strom in einem Wechselrichter 1 liegt daher zwischen dem Mittelpunkt 5 und der Netzdrossel 10.

Auf das Funktionsprinzip der Messeinrichtungen 9 und 18 kommt es nicht entscheidend an. Es kann jedoch vorteilhaft sein, als Messeinrichtungen 9 und 18 Delta-Sigma-Wandler einzusetzen, bei denen es sich um Analog/Digital-Wandler mit sehr hoher Auflösung handelt.

Bei dem anhand von Fig. 2 erläuterten Wechselrichter 1 kann auch auf den Schutzwiderstand 13 verzichtet werden, weil allein durch das Ansteuern der Schaltelemente 3 und 4 zum Erzeugen des Wechselstroms zu dem Erdungspunkt 15 die Amplitude des Stroms begrenzt werden kann.

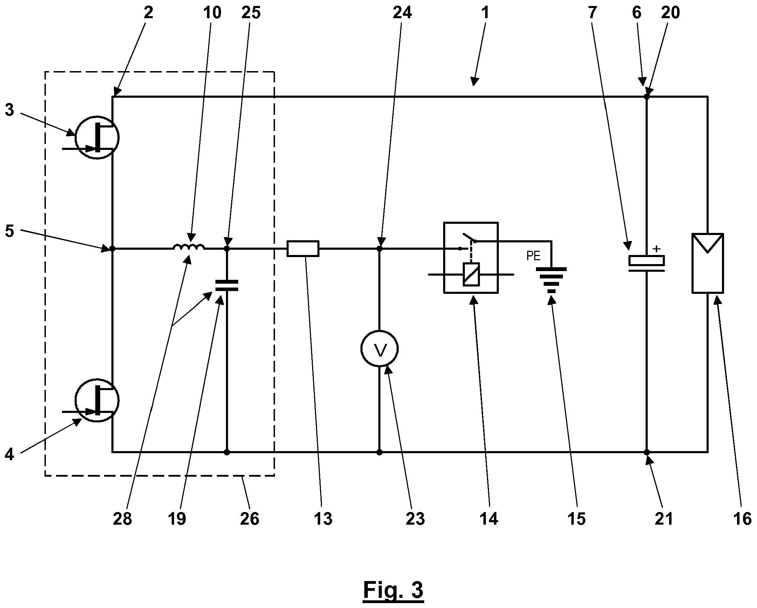

In der Darstellung von wesentlichen Teilen des erfindungsgemäßen Wechselrichters 1 gemäß **Fig. 3** ist der Netzschalter 11 nicht dargestellt, obwohl er tatsächlich vorhanden ist. Tatsächlich bei dieser Ausführungsform des Wechselrichters 1 nicht vorhanden ist ein Messwiderstand 8 für den von dem Mittelpunkt 5 der Halbbrücke 2 bei geschlossenem Erdschalter 14 und angesteuerten Schaltelementen 3 und 4 zu dem Erdungspunkt 15 fließenden Strom. Stattdessen wird hier mit einer Messeinrichtung 23 eine Spannung zwischen einem Punkt 24 auf der Verbindung zwischen dem Mittelpunkt 5 und dem Erdungspunkt 15 und einem der Pole der Zwischenkreisspannung, hier dem negativen Pol, gemessen. Dabei liegt der Punkt 24 zwischen dem Schutzwiderstand 13 und dem Erdungspunkt 15, hier genauer zwischen dem Schutzwiderstand 13 und dem Erdschalter 14, welcher hier zwischen dem Schutzwiderstand 13 und dem Erdungspunkt 15 angeordnet ist. Wenn die Spannung zwischen dem Mittelpunkt 5 und demselben Pol der Zwischenkreisspannung, mit dem die Messeinrichtung 23 verbunden ist, bekannt ist, d. h. die treibende Spannung des über die Verbindung zu dem Erdungspunkt 15 fließenden Stroms gegenüber diesem Pol der Zwischenkreisspannung, kann nach der Maschenregel der Spannungsabfall über dem Schutzwiderstand 13 bestimmt werden und hieraus der Strom, der durch den Schutzwiderstand 13 zu dem Erdungspunkt 15 fließt, berechnet werden. Ein zusätzlicher Messwiderstand 8 wird hierbei nicht benötigt.

Bei dem Wechselrichter 1 gemäß Fig. 3 kann ebenso wie bei dem Wechselrichter 1 gemäß Fig. 2 nicht nur eine einen Wechselstrom über die Verbindung zu dem Erdungspunkt 15 treibende Wechselspannung an dem Filterausgang 25 gestellt werden, die den gesamten Bereich der Zwischenkreisspannung überspannt, d. h. deren negatives Maximum der Spannung des negativen Pols der Zwischenkreisspannung gegenüber Erde und deren positives Maximum der Spannung des positiven Pols der Zwischenkreisspannung gegenüber Erde entspricht. Vielmehr können innerhalb dieser Grenzen auch andere treibende Spannungen gegenüber Erde an dem Filterausgang 25 gestellt werden, und zwar sowohl Wechselspannungen als auch Gleichspannungen, d. h. Spannungen, die über längere Zeiträume konstant gehalten werden. Beides ist durch Takten der Schaltelemente 3 und 4, beispielsweise nach den Grundsätzen der Pulsweitenmodulation, möglich, wobei sich durch unterschiedliche Pulsweiten unterschiedliche Spannungen zwischen den Spannungen der beiden Pole der Zwischenkreisspannung gegenüber Erde an dem Filterausgang 25 einstellen. Auf diese Weise eingestellte Wechselspannungen an dem Filterausgang 25 können auch solche sein, die ihre Polarität gegenüber Erde nicht ändern, so dass auch der über die Verbindung zu dem Erdungspunkt 15 fließende Strom seine Stromflussrichtung nicht ändert.

Bei offenem Erdschalter 14 kann die Messeinrichtung 23 zur Messung der Spannung am Ausgang des Wechselrichters 1 hinter einem Netzfilter des Wechselrichters 1, bestehend aus der Netzdrossel 10 und dem Filterkondensator 19, verwendet werden.

Im linken Teil von Fig. 3 sind die der eigentlichen Schaltung des Wechselrichters 1 zugehörigen Bauteile von einer gepunkteten Linie 26 umschlossen. Darin ist auch der Filterkondensator 19 angeordnet. Ob der Filterkondensator 19 tatsächlich vorhanden und wie dargestellt kontaktiert ist, hängt jedoch von der Topologie des jeweiligen Wechselrichters 1 ab.

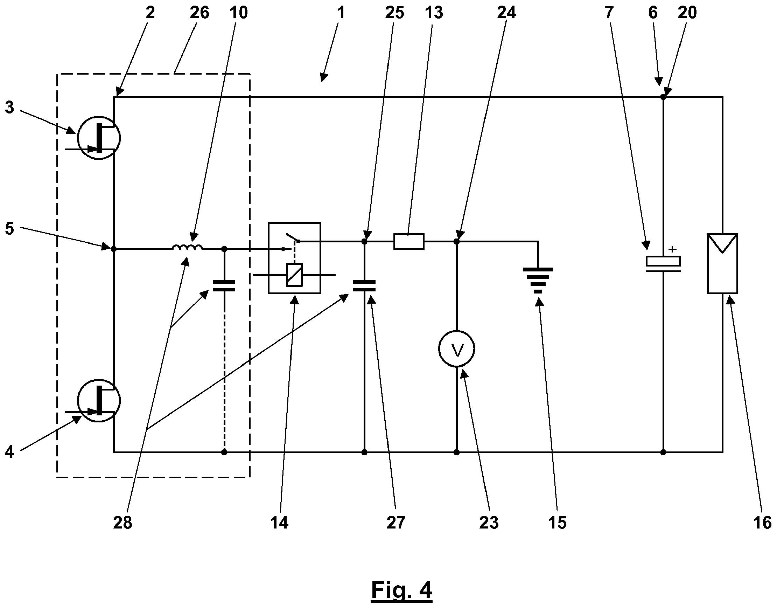

**Fig. 4** zeigt in einer Fig. 3 entsprechenden Darstellung noch eine weitere Ausführungsform eines erfindungsgemäßen Wechselrichters. Diese weist folgende Unterschiede gegenüber der Ausführungsform gemäß Fig. 3 auf: Der Erdschalter 14 ist zwischen der Netzdrossel 10 und dem Schutzwiderstand 13 angeordnet, und zwar genauer zwischen einem je nach vorliegender Wechselrichtertopologie im Bereich des Wechselrichters 1 mit dem negativen Pol der Zwischenkreisspannung verbundenen Filterkondensator 19, wobei dessen optionale Verbindung durch eine gestrichelte Linie angedeutet ist, und einem zusätzlichen Filterkondensator 27, der an den Filterausgang 25 angeschlossen ist. Bei geöffnetem Erdschalter 14 ist dieser zusätzliche Filterkondensator 27 von dem Wechselrichter getrennt und beeinflusst dessen Verhalten nicht. Bei geschlossenem Erdschalter eliminiert der Filterkondensator 27 im Sinne einer Glättungskapazität höherfrequente Schwankungen der treibenden Spannung an dem Mittelpunkt 5, die mit der Schaltfrequenz der Schaltelemente 3 auftreten. Das Filter 28, an dessen Filterausgang 25 die den Strom zu dem Erdungspunkt treibende Spannung anliegt, schließt hier daher auch den Filterkondensator 27 ein. Aufgrund des Filterkondensators 27 können die außerhalb der punktierten Linie 26, d. h. außerhalb der eigentlichen Wechselrichtertopologie, angeordneten Bauteile unabhängig von der tatsächlichen Topologie des Wechselrichters 1 ausgebildet werden. Allerdings kann die hier hinter dem Erdschalter 14 liegende Messeinrichtung 23 nur bei geschlossenem Erdschalter 14 und damit nicht zur Messung der Spannung am Ausgang der Brücke des Wechselrichters 1 verwendet werden. Einen darüber hinausgehenden funktionellen Unterschied zwischen den Ausführungsformen des Wechselrichters 1 gibt es zwischen den Fig. 3 und 4 nicht.

### BEZUGSZEICHENLISTE

- 1: Wechselrichter
- 2: Halbbrücke
- 3: Schaltelement
- 4: Schaltelement
- 5: Mittelpunkt
- 6: Gleichspannungszwischenkreis
- 7: Zwischenkreiskondensator
- 8: Messwiderstand
- 9: Messeinrichtung
- 10: Netzdrossel
- 11: Netzschalter
- 12: Messwiderstand
- 13: Schutzwiderstand
- 14: Erdschalter
- 15: Erdungspunkt
- 16: Stromquelle
- 17: Filterkondensator
- 18: zusätzliche Messeinrichtung
- 19: Filterkondensator
- 20: Pol
- 21: Pol
- 22: Wechselschalter
- 23: Messeinrichtung
- 24: Punkt
- 25: Filterausgang
- 26: Linie
- 27: Filterkondensator
- 28: Filter

Einen darüber hinausgehenden funktionellen Unterschied zwischen den Ausführungsformen des Wechselrichters 1 gibt es zwischen den Fig. 3 und 4 nicht.

### BEZUGSZEICHENLISTE

- 1: Wechselrichter
- 2: Halbbrücke
- 3: Schaltelement
- 4: Schaltelement
- 5: Mittelpunkt
- 6: Gleichspannungszwischenkreis
- 7: Zwischenkreiskondensator
- 8: Messwiderstand
- 9: Messeinrichtung
- 10: Netzdrossel
- 11: Netzschalter
- 12: Messwiderstand
- 13: Schutzwiderstand
- 14: Erdschalter
- 15: Erdungspunkt
- 16: Stromquelle
- 17: Filterkondensator
- 18: zusätzliche Messeinrichtung
- 19: Filterkondensator
- 20: Pol
- 21: Pol
- 22: Wechselschalter
- 23: Messeinrichtung
- 24: Punkt
- 25: Filterausgang
- 26: Linie
- 27: Filterkondensator
- 28: Filter

## Patentansprüche

1. Verfahren zur Messung eines Isolationswiderstands für einen Wechselrichter (1), der mindestens eine Halbbrücke (2) mit zwei aktiven Schaltelementen (3, 4) zum Treiben eines Ausgangsstroms aufweist, mit den Schritten
- nacheinander Herstellen einer Verbindung der beiden ungeerdeten Pole (20, 21) einer Zwischenkreisspannung des Wechselrichters (1) mit einem Erdungspunkt (15) und
- Messen eines über die Verbindung zu dem Erdungspunkt (15) fließenden Stroms,
wobei ein zwischen den Schaltelementen (3, 4) liegender Mittelpunkt (5) der Halbbrücke (2) durch Schließen eines Erdschalters (14) mit dem Erdungspunkt (15) verbunden wird und dass der mit dem Erdungspunkt (15) verbundene Mittelpunkt (5) mittels der Schaltelemente (3, 4) der Halbbrücke (2) nacheinander mit den beiden Polen (20, 21) der an der Halbbrücke anliegenden Zwischenkreisspannung des Wechselrichters (1) verbunden wird, um die Verbindung zum Messen des zu dem Erdungspunkt (15) fließenden Stroms herzustellen,
**dadurch gekennzeichnet, dass** zum Messen des jeweils zu dem Erdungspunkt (15) fließenden Stroms eine Spannung gemessen wird, die zwischen einem Punkt (24), der zwischen einem Schutzwiderstand (13) für den Erdschalter (14) und dem Erdungspunkt (15) liegt, und einem der Pole (20, 21) der Zwischenkreisspannung abfällt, wobei eine den Strom zu dem Erdungspunkt (15) treibende Spannung relativ zu dem einen der Pole (20, 21) der Zwischenkreisspannung erfasst wird oder aufgrund einer definierten Ansteuerung der Schaltelemente (3, 4) der Halbbrücke (2) bekannt ist.

2. Verfahren nach Anspruch 1, **dadurch gekennzeichnet, dass** der Mittelpunkt (5) der Halbbrücke (2) zum Messen des zu dem Erdungspunkt (15) fließenden Stroms von einem im normalen Betrieb des Wechselrichters (1) angeschlossenen Wechselstromnetz getrennt wird.

3. Verfahren nach einem der Ansprüche 1 und 2, **dadurch gekennzeichnet, dass** die Schaltelemente (3, 4) nacheinander geschlossen werden, um nacheinander zwei Gleichströme von den beiden Polen (20, 21) der Zwischenkreisspannung über die Verbindung zu dem Erdungspunkt (15) fließen zu lassen.

4. Verfahren nach einem der Ansprüche 1 und 2, **dadurch gekennzeichnet, dass** die Schaltelemente (3, 4) angesteuert werden, um einen Wechselstrom durch eine Netzdrossel (10) des Wechselrichters (1) über die Verbindung zu dem Erdungspunkt (15) fließen zu lassen, der eine um mindestens einen Faktor 2, optional um mindestens einen Faktor 5, 10, 50 oder 100 längere Periodendauer aufweist als ein im normalen Betrieb des Wechselrichters (1) durch die Netzdrossel (10) ausgegebener Wechselstrom.

5. Verfahren nach einem der Ansprüche 1 und 2, **dadurch gekennzeichnet, dass** die Schaltelemente (3, 4) angesteuert werden, um an einem Filterausgang (25) eines dem Mittelpunkt (5) der Halbbrücke (2) nachgeschalteten Filters (28) mindestens eine treibende Spannung für den durch eine Netzdrossel (10) des Wechselrichters (1) über die Verbindung zu dem Erdungspunkt (15) fließenden Strom einzustellen, die zwischen den Spannungen der Pole (20, 21) der Zwischenkreisspannung gegenüber Erde liegt.

6. Verfahren nach einem der Ansprüche 1 bis 5, **dadurch gekennzeichnet, dass** die den jeweiligen Strom über die Verbindung zu dem Erdungspunkt (15) treibende Spannung mit einer zusätzlichen Messeinrichtung (18) gemessen wird.

7. Wechselrichter (1) mit mindestens einer zwei aktive Schaltelemente (3, 4) aufweisenden Halbbrücke (2) zum Treiben eines Ausgangsstroms und mit einer Vorrichtung zum Messen eines Isolationswiderstands, wobei die Vorrichtung eingerichtet ist,
- nacheinander eine Verbindung der beiden ungeerdeten Pole (20, 21) einer Zwischenkreisspannung des Wechselrichters (1) mit einem Erdungspunkt (15) herzustellen und
- einen über die Verbindung zu dem Erdungspunkt (15) fließenden Strom zu messen wobei die Vorrichtung einen Erdschalter (14) aufweist, mit dem ein zwischen den Schaltelementen (3, 4) liegender Mittelpunkt (5) der Halbbrücke (2) mit dem Erdungspunkt (15) verbindbar ist, und wobei die Vorrichtung eingerichtet ist, den mit dem Erdungspunkt (15) verbundenen Mittelpunkt (5) mittels der Schaltelemente (3, 4) der Halbbrücke (2) nacheinander mit den beiden Polen (20, 21) der an der Halbbrücke (2) anliegenden Zwischenkreisspannung des Wechselrichters (1) zu verbinden, um die Verbindung zum Messen des zu dem Erdungspunkt (15) fließenden Stroms herzustellen,
**dadurch gekennzeichnet, dass** die Vorrichtung eine Messeinrichtung (23) aufweist, die eingerichtet ist, zum Messen des jeweils zu dem Erdungspunkt (15) fließenden Stroms eine Spannung zu messen, die zwischen einem Punkt (24), der zwischen einem Schutzwiderstand (13) für den Erdschalter (14) und dem Erdungspunkt (15) liegt, und einem der Pole (20, 21) der Zwischenkreisspannung anliegt.

8. Wechselrichter (1) nach Anspruch 7, **dadurch gekennzeichnet, dass** die Vorrichtung eingerichtet ist, einen Netzschalter (11) des Wechselrichters (1) zu öffnen, um den Mittelpunkt (5) der Halbbrücke (2) zum Messen des zu dem Erdungspunkt (15) fließenden Stroms von einem im normalen Betrieb des Wechselrichters (1) angeschlossenen Wechselstromnetz zu trennen.

9. Wechselrichter (1) nach einem der Ansprüche 7 und 8, **dadurch gekennzeichnet, dass** die Vorrichtung eingerichtet ist, die Schaltelemente (3, 4) nacheinander zu schließen, um nacheinander zwei Gleichströme von den beiden Polen (20, 21) der Zwischenkreisspannung über die Verbindung zu dem Erdungspunkt (15) fließen zu lassen.

10. Wechselrichter (1) nach einem der Ansprüche 7 und 8, **adurch gekennzeichnet**, dass die Vorrichtung eingerichtet ist, die Schaltelemente (3, 4) anzusteuern, um einen Wechselstrom über die Verbindung durch eine Netzdrossel (10) des Wechselrichters (1) zu dem Erdungspunkt (15) fließen zu lassen, der eine um mindestens einen Faktor 2, optional um mindestens einen Faktor 5, 10, 50 oder 100 längere Periodendauer aufweist als ein im normalen Betrieb des Wechselrichters (1) durch die Netzdrossel (10) ausgegebener Wechselstrom.

11. Wechselrichter (1) nach einem der Ansprüche 7 und 8, **dadurch gekennzeichnet, dass** die Vorrichtung eingerichtet ist, die Schaltelemente (3, 4) anzusteuern, um an einem Filterausgang (25) eines dem Mittelpunkt (5) der Halbbrücke (2) nachgeschalteten Filters (28) mindestens eine treibende Spannung für den durch eine Netzdrossel (10) des Wechselrichters (1) über die Verbindung zu dem Erdungspunkt (15) fließenden Strom einzustellen, die zwischen den Spannungen der Pole (20, 21) der Zwischenkreisspannung gegenüber Erde liegt.

12. Wechselrichter (1) nach einem der Ansprüche 7 bis 11, **dadurch gekennzeichnet, dass** die Vorrichtung eine zusätzliche Messeinrichtung (18) aufweist, um eine den jeweiligen Strom über die Verbindung zu dem Erdungspunkt (15) treibende Spannung zu messen.

13. Wechselrichter (1) nach einem der Ansprüche 7 bis 12, **dadurch gekennzeichnet, dass** der Punkt (24) zwischen dem Schutzwiderstand (13) und dem Erdschalter (14) liegt.

14. Wechselrichter (1) nach einem der Ansprüche 7 bis 12, **dadurch gekennzeichnet, dass** der Schutzwiderstand (13) zwischen dem Erdschalter (14) und dem Erdungspunkt (15) liegt.

15. Wechselrichter (1) nach einem der Ansprüche 7 bis 14, **dadurch gekennzeichnet, dass** an einem Filterausgang (25) zwischen einer Netzdrossel (10) des Wechselrichters (1) und dem Schutzwiderstand (13) ein Filterkondensator (27) zwischen die Verbindung zu dem Erdungspunkt (15) und den einen der Pole (20, 21) der Zwischenkreisspannung geschaltet ist.

## Claims

1. A method for measuring an insulation resistance for an inverter (1) that has at least one half-bridge (2) comprising two active switching elements (3, 4) for driving an output current, the method comprising the steps
- producing, one after the other, a connection between the two ungrounded terminals (20, 21) of a DC link voltage of the inverter (1) and a grounding point (15), and
- measuring a current flowing via the connection to the grounding point (15),
wherein a center point (5) of the half-bridge (2) positioned between the switching elements (3, 4) is connected to the grounding point (15) by closing of a grounding switch (14), and in that the center point (5) connected to the grounding point (15) is connected to the two terminals (20, 21) of the DC link voltage of the inverter (1) present at the half-bridge one after the other by means of the switching elements (3, 4) of the half-bridge (2) in order to produce the connection for measuring the current flowing to the grounding point (15), **characterized in that** in order to measure the current flowing in each case to the grounding point (15), a voltage is measured that is present between a point (24) positioned between a protective resistor (13) for the grounding switch (14) and the grounding point (15) and one of the terminals (20, 21) of the DC link voltage, wherein a voltage that drives the current to the grounding point (15) relative to the one of the terminals (20, 21) of a DC link voltage is measured or is known owing to a defined actuation of the switching elements (3, 4) of the half-bridge (2).

2. The method as claimed in claim 1, **characterized in that** the center point (5) of the half-bridge (2) is disconnected from an AC grid that is connected during normal operation of the inverter (1) in order to measure the current flowing to the grounding point (15).

3. The method as claimed in claim 1 or 2, **characterized in that** the switching elements (3, 4) are closed one after the other in order to allow two direct currents to flow one after the other from the two terminals (20, 21) of the DC link voltage via the connection to the grounding point (15).

4. The method as claimed in claim 1 or 2, **characterized in that** the switching elements (3, 4) are actuated in order to allow an alternating current to flow through a line choke (10) of the inverter (1) via the connection to the grounding point (15) that has a period that is longer than that of an alternating current output by the line choke (10) during normal operation of the inverter (1) by at least a factor of 2, optionally by at least a factor of 5, 10, 50 or 100.

5. The method as claimed in claim 1 or 2, **characterized in that** the switching elements (3, 4) are actuated in order to set at least one driving voltage for the current flowing through a line choke (10) of the inverter (1) via the connection to the grounding point (15) that is between the voltages of the terminals (20, 21) of the DC link voltage with respect to ground at a filter output (25) of a filter (28) connected downstream of the center point (5) of the half-bridge (2).

6. The method as claimed in one of claims 1 to 5, **characterized in that** the voltage driving the respective current via the connection to the grounding point (15) is measured by an additional measuring device (18).

7. An inverter (1) comprising at least one half-bridge (2) having two active switching elements (3, 4) for driving an output current and comprising an apparatus for measuring an insulation resistance, wherein the apparatus is configured to
- produce, one after the other, a connection of the two ungrounded terminals (20, 21) of a DC link voltage of the inverter (1) to a grounding point (15), and
- measure a current flowing via the connection to the grounding point (15),
wherein the apparatus has a grounding switch (14), by means of which a center point (5), positioned between the switching elements (3, 4), of the half-bridge (2) is connectable to the grounding point (15), and wherein the apparatus is configured to connect the center point (5) connected to the grounding point (15) to the two terminals (20, 21) of the DC link voltage present at the half-bridge (2) of the inverter (1) one after the other by means of the switching elements (3, 4) of the half-bridge (2) in order to produce the connection for measuring the current flowing to the grounding point (15) **characterized in that** the apparatus comprises a measuring device (23) that is configured to measure a voltage that is present between a point (24) positioned between a protective resistor (13) for the grounding switch (14) and the grounding point (15) and one of the terminals (20, 21) of the DC link voltage for measuring the current flowing in each case to the grounding point (15).

8. The inverter (1) as claimed in claim 7, **characterized in that** the apparatus is configured to open a mains switch (11) of the inverter (1) in order to disconnect the center point (5) of the half-bridge (2) from an AC grid that is connected during normal operation of the inverter (1) in order to measure the current flowing to the grounding point (15).

9. The inverter (1) as claimed in claim 7 or 8, **characterized in that** the apparatus is configured to close the switching elements (3, 4) one after the other in order to allow two direct currents to flow, one after the other, from the two terminals (20, 21) of the DC link voltage via the connection to the grounding point (15).

10. The inverter (1) as claimed in claim 7 or 8, **characterized in that** the apparatus is configured to actuate the switching elements (3, 4) in order to allow an alternating current to flow via the connection through a line choke (10) of the inverter (1) to the grounding point (15) that has a longer period than that of an alternating current output by the line choke (10) during normal operation of the inverter (1) by at least a factor of 2, optionally by at least a factor of 5, 10, 50 or 100.

11. The inverter (1) as claimed in claim 7 or 8, **characterized in that** the apparatus is configured to actuate the switching elements (3, 4) in order to set at a filter output (25) of a filter (28) connected downstream of the center point (5) of the half-bridge (2) at least one driving voltage for the current flowing through a line choke (10) of the inverter (1) via the connection to the grounding point (15) that is between the voltages of the terminals (20, 21) of the DC link voltage with respect to ground.

12. The inverter (1) as claimed in one of claims 7 to 11, **characterized in that** the apparatus has an additional measuring device (18) in order to measure a voltage driving the respective current via the connection to the grounding point (15).

13. The inverter (1) as claimed in one of claims 7 to 12, **characterized in that** the point (24) is positioned between the protective resistor (13) and the grounding switch (14).

14. The inverter (1) as claimed in one of claims 7 to 12, **characterized in that** the protective resistor (13) is positioned between the grounding switch (14) and the grounding point (15).

15. The inverter (1) as claimed in one of claims 7 to 14, **characterized in that** a filter capacitor (27) is connected between the connection to the grounding point (15) and one of the terminals (20, 21) of the DC link voltage at a filter output (25) between a line choke (10) of the inverter (1) and the protective resistor (13).

## Revendications

1. Procédé de mesure d'une résistance d'isolation pour un onduleur (1), lequel possède au moins un demi-pont (2) pourvu de deux éléments de commutation actifs (3, 4) destinés à commander un courant de sortie, comprenant les étapes suivantes
- établissement successif d'une liaison des deux pôles non reliés à la terre (20, 21) d'une tension de circuit intermédiaire de l'onduleur (1) avec un point de mise à la terre (15) et
- mesure d'un courant qui circule par la liaison vers le point de mise à la terre (15),
un point central (5) du demi-pont (2) qui se trouve entre les éléments de commutation (3, 4) étant relié au point de mise à la terre (15) par fermeture d'un commutateur de terre (14) et le point central (5) qui est relié au point de mise à la terre (15) étant relié successivement, au moyen des éléments de commutation (3, 4) du demi-pont (2), aux deux pôles (20, 21) de la tension de circuit intermédiaire de l'onduleur (1) appliquée au demi-pont afin d'établir la liaison servant à mesurer le courant qui circule vers le point de mise à la terre (15),
**caractérisé en ce que** la mesure du courant qui circule respectivement vers le point de mise à la terre (15) est réalisée en mesurant une tension qui chute entre un point (24) se trouvant entre une résistance de protection (13) pour le commutateur de terre (14) et le point de mise à la terre (15), et l'un des pôles (20, 21) de la tension de circuit intermédiaire, une tension qui commande le courant vers le point de mise à la terre (15) par rapport à l'un des pôles (20, 21) de la tension de circuit intermédiaire étant détectée ou étant connue en raison d'une excitation définie des éléments de commutation (3, 4) du demi-pont (2).

2. Procédé selon la revendication 1, **caractérisé en ce que** pour la mesure du courant qui circule vers le point de mise à la terre (15), le point central (5) du demi-pont (2) est déconnecté d'un réseau de tension alternative qui est raccordé pendant le fonctionnement normal de l'onduleur (1).

3. Procédé selon l'une des revendications 1 et 2, **caractérisé en ce que** les éléments de commutation (3, 4) sont fermés l'un après l'autre afin de laisser passer l'un après l'autre deux courants continus depuis les deux pôles (20, 21) de la tension de circuit intermédiaire par la liaison vers le point de mise à la terre (15).

4. Procédé selon l'une des revendications 1 et 2, **caractérisé en ce que** les éléments de commutation (3, 4) sont excités pour laisser passer un courant alternatif à travers une inductance de réseau (10) de l'onduleur (1) par la liaison vers le point de mise à la terre (15), lequel possède une durée de période plus longue d'au moins un facteur 2, facultativement d'au moins un facteur 5, 10, 50 ou 100, qu'un courant alternatif délivré à travers l'inductance de réseau (10) pendant le fonctionnement normal de l'onduleur (1).

5. Procédé selon l'une des revendications 1 et 2, **caractérisé en ce que** les éléments de commutation (3, 4) sont excités pour régler à une sortie de filtre (25) d'un filtre (28) branché en aval du point central (5) du demi-pont (2) au moins une tension de commande pour le courant qui circule à travers une inductance de réseau (10) de l'onduleur (1) par la liaison vers le point de mise à la terre (15), laquelle se situe entre les tensions des pôles (20, 21) de la tension de circuit intermédiaire par rapport à la terre.

6. Procédé selon l'une des revendications 1 à 5, **caractérisé en ce que** la tension qui commande le courant respectif par la liaison vers le point de mise à la terre (15) est mesurée avec un appareil de mesure (18) supplémentaire.

7. Onduleur (1) comprenant au moins un demi-pont (2) qui possède deux éléments de commutation actifs (3, 4) destinés à commander un courant de sortie, et comprenant un dispositif destiné à mesurer une résistance d'isolation, le dispositif étant conçu pour
- établir successivement une liaison des deux pôles non reliés à la terre (20, 21) d'une tension de circuit intermédiaire de l'onduleur (1) avec un point de mise à la terre (15) et
- mesurer un courant qui circule par la liaison vers le point de mise à la terre (15),
le dispositif possédant un commutateur de terre (14) avec lequel un point central (5) du demi-pont (2) qui se trouve entre les éléments de commutation (3, 4) peut être relié au point de mise à la terre (15), et le dispositif étant conçu pour relier le point central (5), qui est relié au point de mise à la terre (15), successivement, au moyen des éléments de commutation (3, 4) du demi-pont (2), aux deux pôles (20, 21) de la tension de circuit intermédiaire de l'onduleur (1) appliquée au demi-pont (2) afin d'établir la liaison servant à mesurer le courant qui circule vers le point de mise à la terre (15),
**caractérisé en ce que** le dispositif possède un appareil de mesure (23) qui est conçu pour, en vue de mesurer le courant qui circule respectivement vers le point de mise à la terre (15), mesurer une tension qui est appliquée entre un point (24) qui se trouve entre une résistance de protection (13) pour le commutateur de terre (14) et le point de mise à la terre (15), et l'un des pôles (20, 21) de la tension de circuit intermédiaire.

8. Onduleur (1) selon la revendication 7, **caractérisé en ce que** le dispositif est conçu pour ouvrir un commutateur de réseau (11) de l'onduleur (1) afin de déconnecter d'un réseau de tension alternative qui est raccordé pendant le fonctionnement normal de l'onduleur (1) le point central (5) du demi-pont (2) en vue de mesurer le courant qui circule vers le point de mise à la terre (15).

9. Onduleur (1) selon l'une des revendications 7 et 8, **caractérisé en ce que** le dispositif est conçu pour fermer les éléments de commutation (3, 4) l'un après l'autre afin de laisser passer l'un après l'autre deux courants continus depuis les deux pôles (20, 21) de la tension de circuit intermédiaire par la liaison vers le point de mise à la terre (15).

10. Onduleur (1) selon l'une des revendications 7 et 8, **caractérisé en ce que** le dispositif est conçu pour exciter les éléments de commutation (3, 4) afin de laisser passer un courant alternatif par la liaison à travers une inductance de réseau (10) de l'onduleur (1) vers le point de mise à la terre (15), lequel possède une durée de période plus longue d'au moins un facteur 2, facultativement d'au moins un facteur 5, 10, 50 ou 100, qu'un courant alternatif délivré à travers l'inductance de réseau (10) pendant le fonctionnement normal de l'onduleur (1).

11. Onduleur (1) selon l'une des revendications 7 et 8, **caractérisé en ce que** le dispositif est conçu pour exciter les éléments de commutation (3, 4) afin de régler à une sortie de filtre (25) d'un filtre (28) branché en aval du point central (5) du demi-pont (2) au moins une tension de commande pour le courant qui circule à travers une inductance de réseau (10) de l'onduleur (1) par la liaison vers le point de mise à la terre (15), laquelle se situe entre les tensions des pôles (20, 21) de la tension de circuit intermédiaire par rapport à la terre.

12. Onduleur (1) selon l'une des revendications 7 à 11, **caractérisé en ce que** le dispositif possède un appareil de mesure (18) supplémentaire destiné à mesurer une tension qui commande le courant respectif par la liaison vers le point de mise à la terre (15).

13. Onduleur (1) selon l'une des revendications 7 à 12, **caractérisé en ce que** le point (24) se trouve entre la résistance de protection (13) et le commutateur de terre (14).

14. Onduleur (1) selon l'une des revendications 7 à 12, **caractérisé en ce que** la résistance de protection (13) se trouve entre le commutateur de terre (14) et le point de mise à la terre (15).

15. Onduleur (1) selon l'une des revendications 7 à 14, **caractérisé en ce qu'**un condensateur de filtrage (27) est branché entre la liaison vers le point de mise à la terre (15) et l'un des pôles (20, 21) de la tension de circuit intermédiaire, au niveau d'une sortie de filtre (25) entre une inductance de réseau (10) de l'onduleur (1) et la résistance de protection (13).
